# EUROPÄISCHE PATENTANMELDUNG

(11) **EP 1 770 563 A1**
(43) Veröffentlichungstag der Anmeldung: **04.04.2007**
(21) Anmeldenummer: 05109039.7
(22) Anmeldetag: 29.09.2005
(51) Int. Cl.: G06F 17/50

(54) **Einstellung von Technologien bei flexiblen Bausteinen**

(71) Anmelder: Knipping, Uwe, D-85598 Baldham (DE)
(72) Erfinder: Knipping, Uwe, D-85598 Baldham (DE)
(74) Vertreter: Schneider, Günther Martin

(57) **Zusammenfassung**

Verfahren zum Entwurf einer elektronischen Schaltung mit mindestens zwei Bauelementen auf einer Baugruppe, von denen zumindest eines ein feldprogrammierbares Bauelement, FPGA, ist, mit einer Vielzahl elektrischer Pins, über welche das zumindest eine FPGA elektrisch mit zumindest einem Bauelement verbindbar ist, wobei gemäß einer Baugruppennetzliste der elektronischen Schaltung zumindest ein Teil der elektronischen Schaltung auf zumindest einen Teil des zumindest einen FPGA abgebildet wird; wobei die Pins des zumindest einen FPGA in eine vorbestimmte Anzahl von Gruppen verschiedener Technologien einteilbar sind, wobei den gemäß der Baugruppennetzliste benötigten Pins jeweils eine Technologie zugewiesen wird.

## Beschreibung

Die vorliegende Erfindung betrifft den rechnergestützten Entwurf elektronischer Schaltungen unter Verwendung von digitalen feldprogrammierbaren Bausteinen (field programmable gate array, abgekürzt FPGA), wie sie z.B. für die Realisierung kundenspezifischer Schaltungen sowie den schnellen Aufbau von Hardwarenahen Prototypen komplexer Schaltungen eingesetzt werden.

Digitale elektronische Schaltungen werden heutzutage immer höher in einem Baustein integriert. Die zunehmende Integration erlaubt es, immer komplexere und größere Schaltungen in Gehäusen mit einem ungefähr gleich bleibenden Formfaktor einzubauen. Dies ist möglich, indem die einzelnen internen Komponenten der Bausteine verkleinert werden. Diese zunehmende Miniaturisierung hat zur Folge, dass die elektrischen Spannungen bzw. Ströme, mit denen die Komponenten arbeiten, ebenfalls verringert werden müssen, damit die Bausteine nicht zerstört werden.

Daher haben sich die Anforderungen der Bausteine bezüglich Versorgungsspannung, Schwellwerte zum Erkennen der digitalen logischen "Eins" und der logischen "Null" sowie der Eingangs-/Ausgangsimpedanzen der Anschlüsse (Pins) und Zeitverhalten verändert und müssen ständig neu definiert werden. Diese Werte sind als Eingangs-/Ausgangstechnologie (oder kurz: Technologie) standardisiert.

Heutige Baugruppen haben Bauteile mit unterschiedlichen Technologien implementiert. So sind hohe Übertragungsraten wie z.B. USB-Anschlüsse mit Differenztechnologien realisiert, während hochintegrierte Bausteine nur Technologien unterhalb von 1,8V zulassen. Standardschnittstellen wie z.B. PCI benötigen Technologien mit höheren Spannungen.

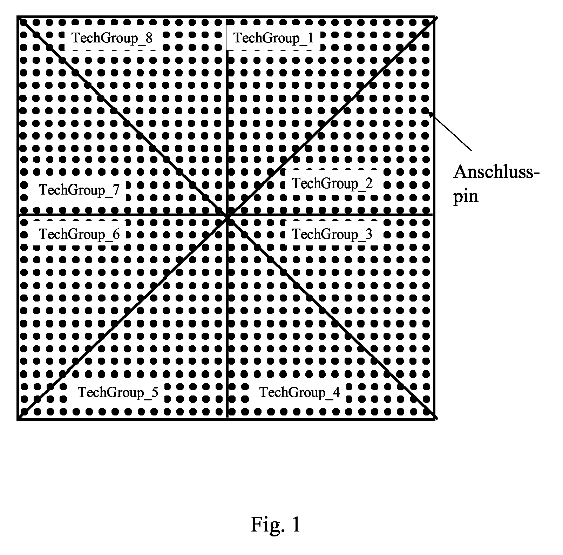

Mit modernen FPGAs können einige aus einer großen Anzahl derartiger Technologien (zur Zeit insgesamt ca. 59) realisiert werden. Diese Technologien lassen sich für die elektrischen Anschlüsse (Pins) der FPGAs einstellen. Jedoch ist die Auswahl der Technologien nicht für jeden Anschluss eines FPGAs einzeln möglich, sondern es können nur jeweils Gruppen davon einer bestimmten Technologie zugeordnet werden. Als Beispiel hierzu sind in Fig. 1 die Anschlusspins und die Gruppeneinteilung eines Virtex 8000 von Xilinx im ff1517-Gehäuse dargestellt. Dieser Baustein hat ca. 1100 frei verfügbare Pins, die in bis zu 8 unabhängige Technologiegruppen Tech_1 - Tech_8 aufgeteilt werden können. D.h. der Baustein kann in bis zu 8 unterschiedliche Technologiebereiche für ihre Eingangs-/Ausgangsschlüsse aufgeteilt werden.

Die gruppenweise Zuordnung schränkt die Benutzung dieser Bausteine ein, da nicht genutzte Anschlüsse einer Gruppe ohne einen erheblichen manuellen Entwurfsaufwand nicht weiter zur Verfügung stehen.

Manche der Technologien sind zueinander kompatibel, dass bedeutet, dass die betreffenden Technologien zusammengeschaltet werden können, andere jedoch nicht. Die Kompatibilität wird im Wesentlichen durch die Anzahl der Leitungen (eine oder zwei bei Differenztechnologien), dem Spannungsbereich zum Erkennen der logischen Eins oder Null, die möglichen Ausgangswerte und die maximal zulässigen Eingangswerte sowie das Zeit- bzw. Frequenzverhalten oder die Erfordernisse der Leitungen bestimmt. Die Kompatibilität kann sich auch auf eine Richtung beschränken. Dies ist z.B. der Fall, wenn ein Ausgang einer Technologie an den Eingang einer anderen Technologie geschaltet werden darf, nicht jedoch umgekehrt.

Des Weiteren besteht die Möglichkeit, inkompatible Technologien durch Zwischenschalten eines passiven oder aktiven Schaltungsnetzwerks kompatibel zu machen. Ein Beispiel für die letzten beiden Fälle ist die TTL-3,3V-Technologie und die 5V-Technologie. Beide haben die gleichen Schaltschwellen zum Erkennen der logischen Eins, jedoch kann die 5V-Technologie eine Spannung treiben, die den Eingang der 3,3V-Technologie zerstört. Somit darf der Ausgang der 3,3V-Technologie an den Eingang der 5V-Technologie geschaltet werden, nicht jedoch umgekehrt (Kompatibilität in einer Richtung). Um diese beiden Technologien in beide Richtungen kompatibel zu machen, könnte als Zusatzschaltung ein Widerstand zur Strombegrenzung oder ein aktiver Pegelwandler zwischengeschaltet werden.

Nach heutigem Stand der Technik gibt es kein automatisches Verfahren, welches unter Berücksichtigung aller technologischen Rahmenbedingungen eine optimale Ausnutzung der FPGA-Bausteine ermöglicht. Vielmehr muss heutzutage für jeden Baustein einzeln die Technologie festgelegt werden, was leicht zu Entwurfsfehlern führen kann.

Aufgabe der Erfindung ist es, eine automatische, technologieübergreifende und netzgesteuerte Anschlussverteilung von allen frei programmierbaren Bausteinen (FPGAs) auf der gesamten Baugruppe zu erreichen, die die Schaltung im Rahmen der verfügbaren Anschlüsse realisierbar macht.

Diese Aufgabe wird durch die Verfahren und die Vorrichtungen gemäß den unabhängigen Ansprüchen gelöst.

Erfindungsgemäß bereitgestellt wird also ein Verfahren zum Entwurf einer elektronischen Schaltung mit mindestens zwei Bauelementen auf einer Baugruppe, von denen zumindest eines ein feldprogrammierbares Bauelement, FPGA, ist, mit einer Vielzahl elektrischer Pins, über welche das zumindest eine FPGA elektrisch mit zumindest einem Bauelement verbindbar ist, wobei gemäß einer Baugruppennetzliste der elektronischen Schaltung zumindest ein Teil der elektronischen Schaltung auf zumindest einen Teil des zumindest einen FPGA abgebildet wird; wobei die Pins des zumindest einen FPGA in eine vorbestimmte Anzahl von Gruppen verschiedener Technologien einteilbar sind, wobei den gemäß der Baugruppennetzliste benötigten Pins jeweils eine Technologie zugewiesen wird, und zwar mit den folgenden Schritten:
Schritt 1) Pins des zumindest einen FPGA, die gemäß der der Baugruppennetzliste mit einem Bauelement verbunden sind und denen noch keine Technologie zugewiesen ist, erhalten die Technologie des mit ihnen verbundenen Bauelements oder der mit ihnen verbundenen FPGA-Technologie-Gruppe zugewiesen, sofern die Technologie für das zumindest eine FPGA verfügbar ist;
Schritt 2) Pins des zumindest einen FPGA, denen in Schritt 1 keine Technologie zugewiesen werden kann, erhalten eine Technologie zugewiesen, die kompatibel ist mir der Technologie des mit ihnen verbundenen Bauelements oder der mit ihnen verbundenen FPGA-Technologie-Gruppe, sofern die kompatible Technologie für das zumindest eine FPGA verfügbar ist;
Schritt 3) Pins eines jeden FPGA, denen jeweils die gleiche Technologie zugewiesen ist, werden zu mindestens einer FPGA-Technologie-Gruppe gleicher Technologie zusammengefasst;
Schritt 4) Sofern gemäß Baugruppennetzliste benötigte Pins übrig bleiben, denen in den vorherigen Schritten keine Technologie zugewiesen werden kann, erhält zumindest eine Gruppe von Pins, denen bereits eine Technologie zugewiesen ist, eine andere jeweils verfügbare Technologie zugewiesen, die kompatibel ist mit der Technologie des mit den Pins dieser Gruppe verbundenen Bauelementes oder der mit den Pins dieser Gruppe verbundenen FPGA-Technologie-Gruppe, und für die übrig gebliebenen Pins werden die Schritte 1 bis 4 erneut durchlaufen.

Weitere Ausgestaltungen der Erfindung können die folgenden Merkmale aufweisen.

Das Verfahren kann weiterhin nach Schritt 2 als zusätzlichen Schritt aufweisen: Pins des zumindest einen FPGA, denen in Schritt 1 und 2 keine Technologie zugewiesen werden kann, erhalten eine Technologie zugewiesen, die kompatibel gemacht werden kann mir der Technologie des mit ihnen verbundenen Bauelements oder der mit ihnen verbundenen FPGA-Technologie-Gruppe, sofern die kompatibel zu machende Technologie für das zumindest eine FPGA verfügbar ist.

Den Gruppen auf der Baugruppe können Technologien gemäß den Schritten 1 bis 3 zugewiesen werden.

Die Kompatibilitäten der Technologien können durch Auswertung einer Datenbank ermittelt werden, in der die Kompatibilitäten zwischen Paaren von Technologien enthalten sind.

Die Datenbank kann zusätzlich Angaben zu eingangsseitigen und ausgangsseitigen Kompatibilitäten der Paare von Technologien enthalten.

Die Datenbank kann zusätzlich schaltungstechnische Maßnahmen enthalten, um Paare von Technologien zueinander kompatibel zu machen.

Wenn gemäß Netzliste ein FPGA mit einem zweiten oder weiteren FPGAs verbunden ist, können die Technologien der Netze zwischen dem einen FPGA und dem zweiten oder weiteren FPGAs wahlweise entweder automatisch oder interaktiv vorgegeben werden.

Es kann ein vergleichender Algorithmus zur Bestimmung der Technologien eingesetzt werden.

Die Ausführung des zusätzlichen Schritts kann durch den Benutzer wählbar sein.

Durch den Benutzer kann zusätzlich vorgebbar sein, ob beim zusätzlichen Schritt solche Technologien berücksichtigt werden, die durch passive schaltungstechnische Maßnahmen kompatibel gemacht werden können, oder solche, die durch aktive schaltungstechnische Maßnahmen kompatibel gemacht werden können.

Technische Rahmenbedingungen für Kompatibilität können vorgebbar und/oder änderbar sein.

Die Schritte können so oft wiederholt werden, bis alle benötigten Pins eine Technologie zugewiesen erhalten haben.

Die Erfindung umfasst auch eine Datenbank mit Daten zur Verwendung für den Entwurf einer elektronischen Schaltung auf einer Baugruppe mit zumindest einem feldprogrammierbaren Bauelement, FPGA, das zur Realisierung zumindest eines Teiles der elektronischen Schaltung bestimmt ist, wobei zumindest ein Teil der elektronischen Schaltung auf zumindest einen Teil des zumindest einen FPGA abgebildet wird; wobei die Pins des zumindest einen FPGA in eine vorbestimmte Anzahl von Gruppen verschiedener Technologien einteilbar sind, wobei jeder Gruppe eine jeweils vorbestimmte Anzahl von Pins des jeweiligen FPGA vorgegeben ist, über welche das FPGA elektrisch mit zumindest einem Bauelement verbindbar ist, wobei den benötigten Pins jeweils eine Technologie zugewiesen wird; wobei die Datenbank Daten enthält, die für alle Paare der Technologien angeben, ob und/oder wie die Paare verbindungskompatibel miteinander sind.

Die Datenbank kann zusätzlich Angaben zu eingangsseitigen und ausgangsseitigen Kompatibilitäten der Paare von Technologien enthalten.

Die Datenbank kann zusätzlich schaltungstechnische Maßnahmen spezifizieren, um Paare von Technologien zueinander kompatibel zu machen.

Die Erfindung ermöglicht es, eine technologieoptimierte, technologieübergreifende Anschlussverteilung für eine Baugruppe mit frei programmierbaren Bausteinen mit gruppenweiser Einstellung der Technologien zu erreichen.

Hierzu wird gemäß der Erfindung nicht nur der individuelle Baustein betrachtet, sondern die gesamte Implementierung berücksichtigt. Dadurch werden Vorgaben durch angeschlossene Bausteine übernommen, oder es können die Technologien für alle angeschlossenen Bausteine auf Basis der Netze gemeinsam umgestellt werden. Die anschließende Einteilung in Gruppen von Technologien und die Verdrahtung (Fälle 1-4) erfolgen ebenfalls automatisch. Diese Automatisierung ermöglicht eine zeitsparende und fehlerfreie Entwicklung einer Baugruppe.

Damit werden mögliche Fehler vermieden und die Möglichkeiten aller Bausteine ausschöpft.

Die Erfindung wird anhand der Zeichnung näher beschrieben. In der Zeichnung zeigen:
- Fig. 1: die Gruppeneinteilung eines FPGAs,
- Fig. 2: einen Schaltplan (a) vor und (b) nach Einteilung in Gruppen,
- Fig. 3: eine Tabelle mit Technologieabhängigkeiten,
- Fig. 4: einen Ausschnitt einer Tabelle zu Zusatzschaltungen,
- Fig. 5: einen Schaltplan mit zwei FPGAs (a) vor und (b) nach Einteilung in Gruppen und
- Fig. 6: ein Flussdiagramm des erfindungsgemäßen Verfahrens.

### Erfindungsgemäß werden zur Lösung des Problems vier Fälle unterschieden:

Fall 1) Der FPGA weist genügend Anschlüsse oder genügend freie Gruppen auf, so dass ein direkter Anschluss eines anderen Bausteins in dessen Technologie ohne ein Wechseln der Technologie möglich ist.

Fall 2) Es sind nicht genügend Anschlüsse oder freie Gruppen vorhanden. Es wird nun überprüft, ob vorhandene Technologien mit der geforderten kompatibel sind, um die noch notwendigen Anschlüsse durchzuführen. Dies kann sowohl in einer Richtung als auch in zwei Richtungen der Fall sein.

Technologien sind kompatibel, wenn die Spannungsschwellen zum sicheren Erkennen einer logischen Eins und Null am Eingang mit den treibenden Spannungswerten am Ausgang zusammenpassen und keine treibende Spannung möglich ist, die zulässige Werte am Eingang übersteigt. Kompatibilität in einer Richtung liegt vor, wenn bei beiden Technologien die Spannungsschwellen zum Erkennen der logischen Eins und Null mit den treibenden Spannungen am Ausgang der treibenden Technologie zusammenpassen, jedoch bei einer Technologie eine Ausgangsspannung erlaubt ist, die die zulässige Eingangsspannung der anderen Technologie überschreitet.

Fall 3) Es sind nicht genügend Anschlüsse oder freie Gruppen vorhanden, und die Anschlüsse an die geforderten Technologien lassen sich nicht durch Aufteilung an andere Technologiegruppen erreichen. In diesem Fall wird eine weitere Technologie gesucht und eingesetzt, die zu den geforderten kompatibel im Sinne des Falles 2) ist und die die entsprechenden Rahmenbedingungen erfüllt.

Fall 4) Eine Kompatibilität lässt sich nur durch eine Zusatzschaltung erreichen.

Diese genannten Fälle werden an einem Beispiel erläutert.

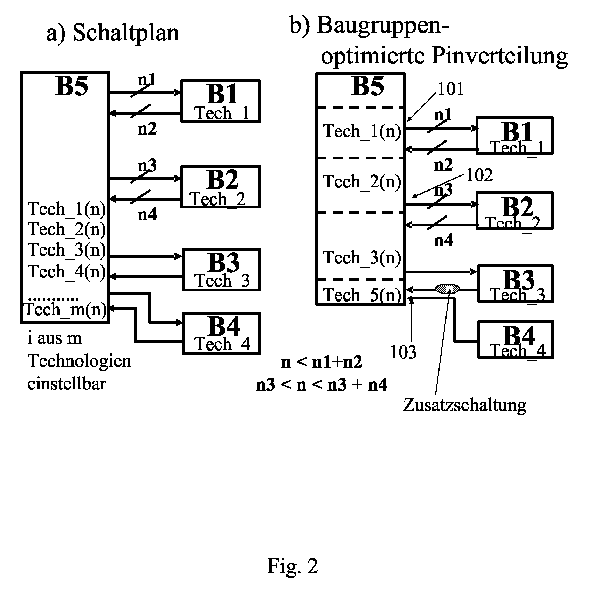

Fig. 2a zeigt eine Baugruppe, in der vier Bausteine B1 - B4 mit einem FPGA-Baustein B5 verbunden sind. Die Bausteine B1 - B4 sind jeweils in den Technologien Tech_1 - Tech_4 realisiert. Der FPGA B5 kann in eine Anzahl verschiedener Technologien unterteilt werden, die in Gruppen (in diesem Beispiel bis zu 4) zu jeweils n Anschlüssen frei einstellbar sind. Die Gesamtzahl verschiedener Technologien, von denen die i Technologien gewählt werden können, ist m bezeichnet. n1, ... ni=n4 sind jeweils die Anzahl der Netze oder Verbindungen, die von einem Bauteil zum anderen unter Berücksichtigung der Richtung gehen. So treiben n1 Anschlüsse von B5 Eingänge von B1, und - in entgegen gesetzter Richtung - treiben n2 Anschlüsse von B 1 Eingänge von B5.

Es gelten n1 + n2 < n sowie n3 < n < n3 +n4.

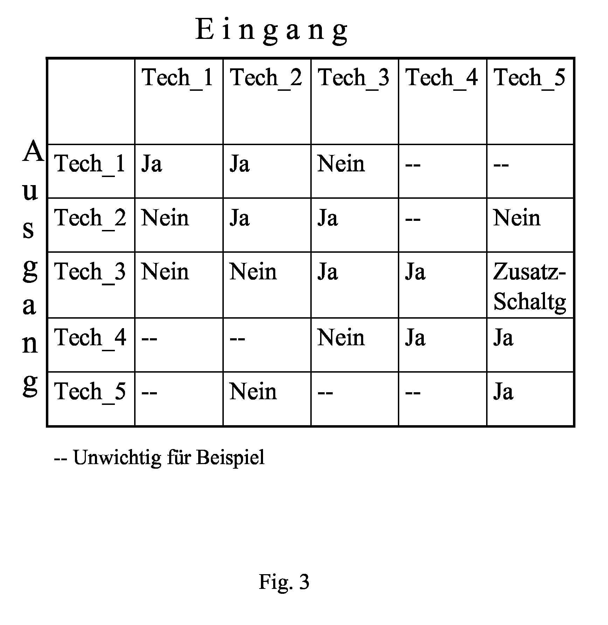

Die Tabelle gemäß Fig. 3 zeigt die Kompatibilität verschiedener Technologien zueinander. Aus Gründen der Einfachheit sind lediglich die für das Beispiel interessierenden Felder ausgefüllt. Z.B. ist der Eingang von Tech_2 kompatibel mit dem Ausgang von Tech_1, in umgekehrter Richtung gilt dies jedoch nicht: Der Eingang von Tech_1 ist nicht kompatibel mit dem Ausgang von Tech_2.

Aufgrund der Anzahl der benötigten Verbindungen bzw. Netze (n1, ... n4) und der begrenzten Anzahl verfügbarer Anschlüsse pro Technologie - also die Zahl n - muss eine Optimierung unter den gegebenen Randbedingungen stattfinden. In dem Beispiel sind die folgenden Gesichtspunkte erkennbar:

Es werden alle 4 Technologiegruppen des Bausteins B5 benötigt, da die 4 Bausteine B1, ...B4 mit 4 verschiedenen Technologien angeschlossen sind.

Ein direkter Anschluss von Baustein B2 an eine Technologiegruppe von B5 ist nicht möglich, da B2 mehr Anschlüsse an B5 benötigt, als in einer Technologiegruppe von B5 vorhanden sind (n < n3+n4).

Hieraus folgt, dass die Kompatibilität von Technologien berücksichtigt werden muss. Im Beispiel wird die einseitige Kompatibilität von Tech_2 und Tech_3 ausgenutzt (vgl. Tabelle der Fig. 2).

B3 und B4 lassen sich aufgrund von fehlenden Pins und Inkompatibilitäten nicht direkt an B5 in den jeweiligen Technologien anschließen. Aus diesem Grund muss eine weitere Technologie (Tech_5) eingesetzt werden, die zu den Technologien Tech_3 und Tech_4 kompatibel ist.

Gemäß der Kompatibilitätstabelle von Fig. 3 kommt Tech_5 in Frage. Hierbei tritt der Sonderfall ein, dass für die Verbindung von B3 (Tech_3) und B5 (Tech_5) noch eine Zusatzschaltung eingefügt werden muss.

Fall 1) Direkte Verbindung der Technologien ist möglich.
Im ersten Schritt wird überprüft, ob alle Netze mit gleichen Technologien miteinander verbunden sind. Mit n1+n2 < n ist dies für B 1 der Fall. Somit kann der Baustein B1 mit B5 direkt verbunden werden, denn es sind genügend Pins für Tech_1 an B5 vorhanden (Siehe Bild 2b, Punkt 101).

Fall 2) Es sind nicht genügend Pins einer Technologiegruppe verfügbar.
Wenn nicht genügend Pins einer Technologiegruppe verfügbar sind (in Fig. 2, Punkt 102: n3 < n < n3 + n4) und alle verfügbaren Gruppen benötigt werden, muss in einem zweiten Schritt auf Kompatibilität mit existierenden Technologien für Eingänge und Ausgänge geprüft werden. Dies ist für B2 durch den Anschluss an verschiedene Technologien von B5 möglich. Hierbei wird ausgenutzt, dass die Ausgangsseite von Technologie 2 kompatibel zur Eingangsseite von Technologie 3 ist. Bei der Untersuchung ist ein Überschneiden mit Fall 3 zu berücksichtigen.

Fall 3) Einschränkung durch Maximalzahl einstellbarer Technologien.

Im Beispiel-FPGA B5 können bis maximal i (Beispiel: i = 4) aus m Technologien eingestellt werden. Weil nicht genügend verschiedene Technologien bzw. entsprechende Pins zur Verfügung stehen, muss in einem weiteren Schritt eine weitere Technologie gesucht werden, die mit mehreren Technologien kompatibel ist. Dies ist im vorliegenden Beispiel die Tech_5, die sowohl zu Tech_4 als auch Tech_3 (siehe Fall 4) kompatibel ist (Punkt 103 in Fig. 2b).

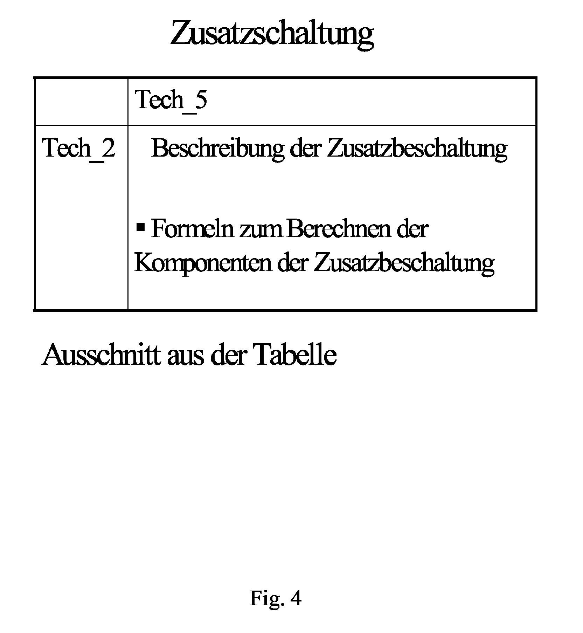

Fall 4) Die Technologien lassen sich nur durch Einbau von externen Komponenten zusammenschalten.
Einige nicht kompatible Technologien lassen sich durch chipexterne Zusatzmaßnahmen wie z.B. den Einbau von Widerstandsnetzwerken kompatibel machen. Hierzu muss der zusätzliche Aufwand bekannt sein, und die Zusatzkomponenten müssen berechnet werden. Diese Information wird in einer Datenbank in einem geeigneten Format vorgehalten, vgl. Fig. 4. Die Implementierung kann automatisch oder interaktiv durch den Benutzer vorgenommen werden. In Fig. 2b ist dieser Fall für die Verbindung 104 von B3 nach B5 dargestellt.

Die Realisierung der erfindungsgemäßen Vorgehensweise erfolgt vorzugsweise mittels einer Software. Diese Software hat in einer Datenbank oder einer datenbankähnlichen Struktur die Informationen aus Fig. 3 und 4 gespeichert. Mit der Software wird die Beschreibung der zu realisierenden Baugruppe eingelesen. Damit sind die Komponenten B1 - B5 und deren elektrische Verbindungen (Netze, dargestellt als Pfeile in Fig. 2) bekannt. Die erste Aufgabe besteht nun darin, die Technologien für jedes Netz festzulegen und anschließend eine Verteilung auf die Gruppen oder interaktiv festzulegen.

Schritt 1: Festlegung der Technologien
Im Beispiel der Fig. 2 sind die geforderten Technologien eindeutig bestimmt, denn sie sind vorgegeben durch die Bausteine B1 bis B4, die in jeweils einer fest vorgegebenen Technologie (B1 in Tech_1, B2 in Tech_2, B3 in Tech_3, B4 in Tech_4) gefertigt sind.

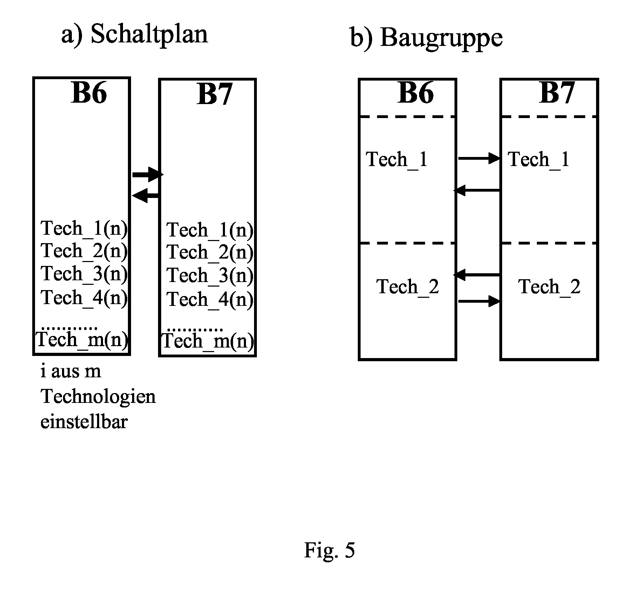

Fig. 5 zeigt zwei FPGAs B6 und B7, die beide jeweils die Zahl von i unterschiedlichen Technologien erlauben. Wegen der Mehrzahl möglicher Technologien für beide Bausteine ist eindeutig festzulegen, welche Technologie für welches Netz verwendet werden soll. Dies kann sowohl interaktiv durch den Benutzer als auch vollautomatisch durch eine einzulesende Datei erfolgen.

Zur Verbindung zweier FPGAs kann ein weiterer Automatismus implementiert sein, bei welchem die Technologien der FPGA-Verbindungen untereinander durch die Erfordernisse der Verbindungen mit den Bausteinen mit fester Technologie bestimmt werden. Ein solcher Fall liegt z.B. vor, wenn beim Beispiel der Figur 5 die FPGAs B6, B7 zusätzlich mit Bauelementen der Technologie Tech_1 und Tech_2 verbunden sind (in Fig. 5 nicht eingezeichnet). Wenn für die Interkommunikation der FPGAs untereinander keine Technologie zwingend vorgeschrieben ist, können unter den Rahmenbedingungen der Realisierbarkeit der Baugruppe verschiedene Technologien für die Verbindungen zwischen den FPGAs gewählt werden. Durch die Wahl von Tech_1 und/oder Tech_2 für die Pins dieser Verbindungen können freie Pins einer Technologiegruppe, die ansonsten mit einem Baustein mit fester Technologie verbunden ist, für FPGA-Verbindungen untereinander verwendet werden. Auf diese Weise können ansonsten frei bleibende Pins von Technologiegruppen genutzt werden. In Fig. 5b) wurde also ein Teil der Netze in Tech_1 und der Rest in Tech_2 gewählt.

Schritt 2: Einteilung der Gruppen
Nach der Festlegung der geforderten Technologien für die Netze erfolgt die Einteilung der Gruppen. Dies erfolgt automatisch durch die Software. Es werden der Reihe nach die Fälle 1 bis 3 durchgegangen. Fall 4 ist optional. Der Benutzer kann vorab festlegen, dass er den Fall 4 nicht oder nur mit passiven Elementen berücksichtigt haben möchte. Dies ist z.B. dann angebracht, wenn die Baugruppe eine bestimmte Größe oder andere Erfordernisse nicht übersteigen darf.

Zuerst wird versucht, eine Lösung nach Fall 1 zu ermitteln. Ist dies nicht möglich, wird ein Ansatz nach Fall 2 versucht. Schlägt dies fehl, wird Fall 3 und - optional - anschließend Fall 4 versucht. Die Implementierung erfolgt mit vergleichenden Algorithmen. Hierbei geben die geforderten Technologien jeweils einen Rahmen bzw. Bereich bezüglich aller Spannungs-, Strom-, Zeit- bzw. Frequenzverhalten etc. vor, aus denen der größte gemeinsame Rahmen der geforderten Technologien gefunden wird. Dies ist die Schnittmenge der Rahmen bzw. Bereiche. Ein Rahmen gibt an, in welchem Bereich sich bestimmte Werte wie z.B. Spannungen bewegen dürfen. Ein Beispiel eines solchen Rahmens ist die minimale Spannung zum Erkennen einer logischen Eins und die maximal zulässige Spannung an diesem Pin. Als Beispiel sei hier ein Rahmen gegeben, der durch das Wertepaar von 1,8V und 2,5V definiert ist. Wenn dies mit einer Technologie mit dem Rahmen des Wertepaars 1,5V und 2V zusammengeschaltet werden soll, ergibt dies den gemeinsamen Rahmen von 1,8V zu 2V. Zu diesem größten gemeinsamen Rahmen wird eine Technologie ausgesucht, die in allen Werten diesem Rahmen entspricht. Sollte keine Technologie nicht gefunden werden, werden unter Berücksichtigung der zu realisierenden Schaltung interaktiv oder automatisch ein oder mehrere Rahmenbedingungen erweitert, so dass eine gemeinsame Technologie durch Zusatzbeschaltung oder Änderung anderer Werte eine gemeinsame Technologie gefunden werden kann.

Das interaktive Verfahren kann wie folgt implementiert werden. Die Software gibt die Daten des größten gemeinsamen Rahmens und die entsprechenden Daten der geforderten Technologien in einer Tabelle an. Hierin wird auch gekennzeichnet, welche Parameter der jeweiligen Technologie den gemeinsamen Rahmen verletzen. Dies kann z.B. dann sein, wenn eine Zusatzschaltung wie Pegelkonverter nicht in der Datenbank existieren oder deren Einsatz die geforderte Systemfrequenz unmöglich machen, da sie eine zu große Laufzeit in die Signalpfade bringen. Im ersten Fall kann der Benutzer einen Konverter integrieren, der existiert aber der Datenbank nicht bekannt ist. Im zweiten Fall kann der Benutzer die Systemfrequenz reduzieren, einen schnelleren Konverter einsetzen, eine neue Konvertierungsschaltung entwickeln und einsetzen oder eine alternative Technologie für einen der Bausteine wählen. Dies kann er z.B. dadurch tun, indem er einen anderen Typ des Bausteins wählt oder diesen anders einstellt, sofern es möglich ist.

Der Wert der Erfindung liegt darin, dass aus der gesamten, unüberschaubaren Vielfalt der Möglichkeiten zur Realisierung der Gesamtschaltung, die, wie der bisher bekannte Ansatz gezeigt hat, nicht lösbar ist, eine kleine, überschaubare Problemstellung übrig lässt, die der Anwender leicht lösen kann.

Das automatische Verfahren kann auf die Änderung von mindestens einer Technologie oder die Einführung von Zusatzkomponenten herauslaufen, sofern letztere im ersten Ansatz nicht freigegeben waren. Des Weiteren kann eine Erweiterung der Rahmenbedingung für einen Baustein das Finden einer Technologie ermöglichen. Eine erweiterte Rahmenbedingung kann z.B. vorliegen, wenn ein Baustein eine 2,5V-Technologie fordert, dieser aber im Zweifelsfall mit einer 3,3V-Technologie verträglich ist. Weitere Rahmenbedingungen sind unter anderen die treibende minimale und maximale Spannung für die logische Null und Eins, die Schwellspannung zum sicheren Erkennen dieser Werte, die zulässigen Spannungen sowie die Eingangsimpedanz. Der Benutzer gibt die Rahmenbedingungen für die automatische Suche vor. Anhand der Tabelle sieht er, welche Parameter verletzt wurden und welche Parameter die automatische Suche nicht zum Erfolg führten. Er kann nun die Parameter gewichten und somit eine Lockerung des Suchalgorithmus ermöglichen. Wenn mehrere Parameter verletzt wurden, gibt der Benutzer vor, in welcher Reihenfolge und bis zu welchen Grenzen er die Rahmenbedingungen gelockert haben möchte. Basierend auf diesen Vorgaben sucht der Algorithmus nun eine Technologie, die den erweiterten Rahmenbedingungen entspricht. Das automatische Verfahren ist sinnvoll, wenn die Ergebnisse der vorhergehenden Untersuchung zu viele Möglichkeiten offen lassen.

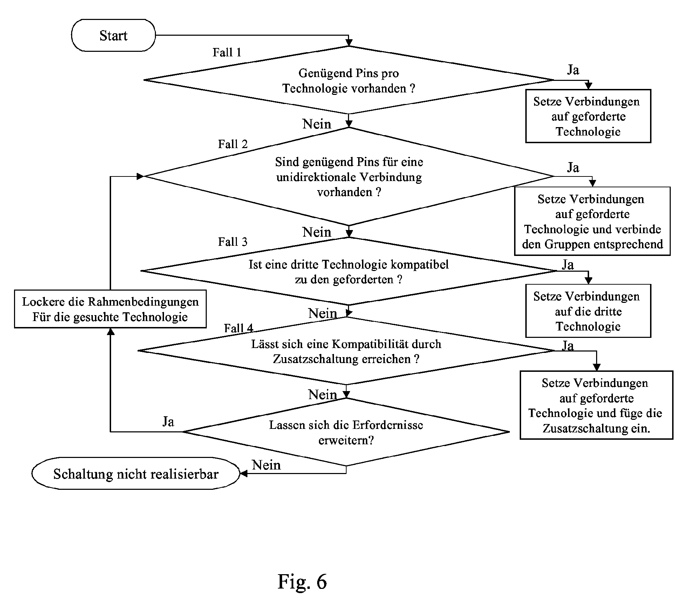

Fig. 6 zeigt eine Übersicht über die erfindungsgemäße Vorgehensweise beim Bestimmen der Technologien und der Gruppen des FPGA.

Zunächst werden die geforderten Technologien festgelegt. Diese richten sich nach den Bausteinen mit fest vorgegebenen Technologien, die gemäß Schaltplan mit dem mindestens einen FPGA verbunden sind.

Sofern die geforderten Technologien in der Anzahl nicht größer als die Maximalzahl i ist, werden die betreffenden Verbindungen gruppiert und auf die jeweilige Technologie gesetzt.

Wenn die Anzahl der geforderten Technologien die maximal mögliche Zahl i realisierbarer Technologien übersteigt, muss die Anzahl der Technologien reduziert werden, indem Kompatibilitäten der einzelnen Technologien zueinander berücksichtigt werden. Derartige Kompatibilitäten beziehen sich insbesondere auf unidirektionale Verbindungen. Wenn genügend Pins für kompatible Verbindungen vorhanden sind, können die Verbindungen auf die geforderte Technologie gesetzt werden.

Soweit die bisher gewählten Technologien zueinander nicht kompatibel sind, müssen stattdessen weitere (dritte) Technologien gesucht werden, die zu den geforderten Technologien kompatibel sind.

Sofern die dritten Technologien nicht direkt kompatibel zu den geforderten sind, wird untersucht, ob dies durch eine Zusatzschaltung erreicht werden kann. Dies geschieht durch Durchsuchen der entsprechenden Datenbank. Dort werden auch die Informationen über die Art und Berechnung der Zusatzschaltung abgerufen.

Die Schritte 2 bis 5 werden so oft durchlaufen, bis alle Netze gruppiert sind, also die Schaltung realisiert werden kann.

## Patentansprüche

1. Verfahren zum Entwurf einer elektronischen Schaltung mit mindestens zwei Bauelementen (B1, B2, ..., B5) auf einer Baugruppe (L), von denen zumindest eines (B5) ein feldprogrammierbares Bauelement, FPGA, ist, mit einer Vielzahl elektrischer Pins, über welche das zumindest eine FPGA (B5) elektrisch mit zumindest einem Bauelement (B1, B2, ..., B5) verbindbar ist,
wobei gemäß einer Baugruppennetzliste der elektronischen Schaltung zumindest ein Teil der elektronischen Schaltung auf zumindest einen Teil des zumindest einen FPGA (B5) abgebildet wird;
wobei die Pins des zumindest einen FPGA (B5) in eine vorbestimmte Anzahl (i) von Gruppen verschiedener Technologien (Tech_1, ... Tech_m) einteilbar sind,
wobei den gemäß der Baugruppennetzliste benötigten Pins jeweils eine Technologie zugewiesen wird, und zwar mit den folgenden Schritten:
Schritt 1) Pins des zumindest einen FPGA, die gemäß der der Baugruppennetzliste mit einem Bauelement (B1, ..., B5) verbunden sind und denen noch keine Technologie zugewiesen ist, erhalten die Technologie des mit ihnen verbundenen Bauelements oder der mit ihnen verbundenen FPGA-Technologie-Gruppe zugewiesen, sofern die Technologie für das zumindest eine FPGA verfügbar ist;
Schritt 2) Pins des zumindest einen FPGA, denen in Schritt 1 keine Technologie zugewiesen werden kann, erhalten eine Technologie zugewiesen, die kompatibel ist mir der Technologie des mit ihnen verbundenen Bauelements oder der mit ihnen verbundenen FPGA-Technologie-Gruppe, sofern die kompatible Technologie für das zumindest eine FPGA verfügbar ist;
Schritt 3) Pins eines jeden FPGA, denen jeweils die gleiche Technologie zugewiesen ist, werden zu mindestens einer FPGA-Technologie-Gruppe gleicher Technologie zusammengefasst;
Schritt 4) Sofern gemäß Baugruppennetzliste benötigte Pins übrig bleiben, denen in den vorherigen Schritten keine Technologie zugewiesen werden kann, erhält zumindest eine Gruppe von Pins, denen bereits eine Technologie zugewiesen ist, eine andere jeweils verfügbare Technologie zugewiesen, die kompatibel ist mit der Technologie des mit den Pins dieser Gruppe verbundenen Bauelementes oder der mit den Pins dieser Gruppe verbundenen FPGA-Technologie-Gruppe, und für die übrig gebliebenen Pins werden die Schritte 1 bis 4 erneut durchlaufen.

2. Verfahren gemäß Anspruch 1, weiterhin nach Schritt 2 den zusätzlichen Schritt aufweisend:
Pins des zumindest einen FPGA, denen in Schritt 1 und 2 keine Technologie zugewiesen werden kann, erhalten eine Technologie zugewiesen, die kompatibel gemacht werden kann mir der Technologie des mit ihnen verbundenen Bauelements oder der mit ihnen verbundenen FPGA-Technologie-Gruppe, sofern die kompatibel zu machende Technologie für das zumindest eine FPGA verfügbar ist.

3. Verfahren gemäß Anspruch 1 oder 2, wobei den Gruppen auf der Baugruppe Technologien gemäß den Schritten 1 bis 3 zugewiesen werden.

4. Verfahren gemäß Anspruch 1, 2 oder 3, wobei die Kompatibilitäten der Technologien durch Auswertung einer Datenbank ermittelt werden, in der die Kompatibilitäten zwischen Paaren von Technologien (Tech_j, Tech_k) enthalten sind.

5. Verfahren gemäß Anspruch 4, wobei die Datenbank zusätzlich Angaben zu eingangsseitigen und ausgangsseitigen Kompatibilitäten der Paare von Technologien (Tech_j, Tech_k) enthält.

6. Verfahren gemäß Anspruch 5, wobei die Datenbank zusätzlich schaltungstechnische Maßnahmen enthält, um Paare von Technologien (Tech_j, Tech_k) zueinander kompatibel zu machen.

7. Verfahren gemäß einem der vorherigen Ansprüche, wobei, wenn gemäß Netzliste ein FPGA mit einem zweiten oder weiteren FPGAs verbunden ist, die Technologien der Netze zwischen dem einen FPGA und dem zweiten oder weiteren FPGAs wahlweise entweder automatisch oder interaktiv vorgegeben werden.

8. Verfahren gemäß einem der vorherigen Ansprüche, wobei ein vergleichender Algorithmus zur Bestimmung der Technologien eingesetzt wird.

9. Verfahren gemäß einem der Ansprüche 2 bis 8, wobei die Ausführung des zusätzlichen Schritts durch den Benutzer wählbar ist.

10. Verfahren gemäß Anspruch 9, wobei durch den Benutzer zusätzlich vorgebbar ist, ob beim zusätzlichen Schritt solche Technologien berücksichtigt werden, die durch passive schaltungstechnische Maßnahmen kompatibel gemacht werden können, oder solche, die durch aktive schaltungstechnische Maßnahmen kompatibel gemacht werden können.

11. Verfahren gemäß einem der Ansprüche 2 bis 10, wobei technische Rahmenbedingungen für Kompatibilität vorgebbar und/oder änderbar sind.

12. Verfahren gemäß einem der vorherigen Ansprüche, wobei die Schritte so oft wiederholt werden, bis alle benötigten Pins eine Technologie zugewiesen erhalten haben.

13. Datenbank mit Daten zur Verwendung für den Entwurf einer elektronischen Schaltung auf einer Baugruppe (L) mit zumindest einem feldprogrammierbaren Bauelement, FPGA, (B1, B2, ..., Bn), das zur Realisierung zumindest eines Teiles der elektronischen Schaltung bestimmt ist, wobei zumindest ein Teil der elektronischen Schaltung auf zumindest einen Teil des zumindest einen FPGA (B5) abgebildet wird; wobei die Pins des zumindest einen FPGA (B5) in eine vorbestimmte Anzahl (i) von Gruppen verschiedener Technologien (Tech_1, ...Tech_m) einteilbar sind, wobei jeder Gruppe eine jeweils vorbestimmte Anzahl (nⱼ) von Pins des jeweiligen FPGA vorgegeben ist, über welche das FPGA elektrisch mit zumindest einem Bauelement (B1, B2, ..., B5) verbindbar ist, wobei den benötigten Pins jeweils eine Technologie zugewiesen wird;
wobei die Datenbank Daten enthält, die für alle Paare (Tech_j, Tech_k) der Technologien (Tech_1, ...Tech_m) angeben, ob und/oder wie die Paare verbindungskompatibel miteinander sind.

14. Datenbank gemäß Anspruch 13, wobei die Datenbank zusätzlich Angaben zu eingangsseitigen und ausgangsseitigen Kompatibilitäten der Paare von Technologien (Tech_j, Tech_k) enthält.

15. Datenbank gemäß Anspruch 13 oder 14, wobei die Datenbank zusätzlich schaltungstechnische Maßnahmen spezifiziert, um Paare von Technologien (Tech_j, Tech_k) zueinander kompatibel zu machen.
